# EUROPÄISCHE PATENTANMELDUNG

(11) **EP 1 001 248 A2**
(43) Veröffentlichungstag der Anmeldung: **17.05.2000**
(21) Anmeldenummer: 99203683.0
(22) Anmeldetag: 03.11.1999
(51) Int. Cl.: G01B 7/30

(54) **Verfahren zur Offset-Kalibrierung eines magnetoresistiven Winkelsensors**

(30) Priorität: 13.11.1998 DE 19852502
(71) Anmelder: Philips Corporate Intellectual Property GmbH, 52064 Aachen (DE); Koninklijke Philips Electronics N.V., 5621 BA Eindhoven (NL)
(72) Erfinder: Waffenschmidt, Eberhard, Habsburgerallee 11, 52064 Achen (DE)
(74) Vertreter: Gössmann, Klemens

(57) **Zusammenfassung**

Die Erfindung bezieht sich auf ein Verfahren zur Offset-Kalibrierung eines magnetoresistiven Winkelsensors zur Richtungsermittlung von magnetischen Feldern, welcher wenigstens eine Wheatstonesche Brücke mit wenigstens vier magnetoresistiven Widerständen aufweist, wobei der Wheatstoneschen Brücke eingangsseitig ein Eingangssignal, insbesondere eine Eingangsspannung, zuführbar ist und wobei die Wheatstonesche Brücke ausgangsseitig zur Lieferung eines Winkelsignals, insbesondere einer Winkelspannung, in Abhängigkeit der Richtung eines die Wheatstonesche Brücke beaufschlagenden magnetischen Feldes vorgesehen ist, wobei die Wheatstonesche Brücke ein erstes und ein zweites Paar von sich jeweils gegenüberliegenden, im wesentlichen parallel zueinander angeordneten magnetoresistiven Widerständen aufweist, wobei das erste und das zweite Paar im wesentlichen orthogonal zueinander angeordnet sind und wobei die Richtung des magnetischen Feldes aus dem von der Wheatstoneschen Brücke gelieferten Winkelsignal mittels einer Auswerteschaltung ermittelbar ist.
Es ist Aufgabe der Erfindung, ein einfaches Verfahren aufzuzeigen hierzu aufzuzeigen.

Hierzu ist vorgesehen, daß in einem ersten Schritt die Wheatstonesche Brücke mit einem Gleichmagnetfeld beaufschlagt wird, welches derart ausgerichtet ist, daß es weder im wesentlichen senkrecht zu den magnetoresistiven Widerständen des ersten Paares noch im wesentlichen senkrecht zu den magnetoresistiven Widerständen des zweiten Paares der Wheatstoneschen Brücke verläuft, daß in einem zweiten Schritt das äußere Gleichmagnetfeld entfernt wird und daß eine Auswerteschaltung in einem dritten Schritt ohne das äußere Gleichmagnetfeld zur Ermittlung eines Offset-Kalibriersignals vorgesehen ist, wobei das von der Wheatstoneschen Brücke ohne Gleichmagnetfeld gelieferte Winkelsignal ein Maß für den Offset der Wheatstoneschen Brücke ist.

## Beschreibung

Die Erfindung bezieht sich auf ein Verfahren zur Offset-Kalibrierung eines magnetoresistiven Winkelsensors zur Richtungsermittlung von magnetischen Feldern, welcher wenigstens eine Wheatstonesche Brücke mit wenigstens vier magnetoresistiven Widerständen aufweist, wobei der Wheatstoneschen Brücke eingangsseitig ein Eingangssignal, insbesondere eine Eingangsspannung, zuführbar ist und wobei die Wheatstonesche Brücke ausgangsseitig zur Lieferung eines Winkelsignals, insbesondere einer Winkelspannung, in Abhängigkeit der Richtung eines die Wheatstonesche Brücke beaufschlagenden magnetischen Feldes vorgesehen ist, wobei die Wheatstonesche Brücke ein erstes und ein zweites Paar von sich jeweils gegenüberliegenden, im wesentlichen parallel zueinander angeordneten magnetoresistiven Widerständen aufweist, wobei das erste und das zweite Paar im wesentlichen orthogonal zueinander angeordnet sind und wobei die Richtung des magnetischen Feldes aus dem von der Wheatstoneschen Brücke gelieferten Winkelsignal (mittels einer Auswerteschaltung) ermittelbar ist, sowie auf eine Sensorvorrichtung zur Winkelmessung eines Magnetfeldes mit einem magnetoresistiven Winkelsensor, welcher wenigstens eine Wheatstonesche Brücke mit wenigstens vier magnetoresistiven Widerständen aufweist, wobei der Wheatstoneschen Brücke eingangsseitig ein Eingangssignal, insbesondere eine Eingangsspannung, zuführbar ist und wobei der Winkelsensor ausgangsseitig zur Lieferung eines Winkelsignals in Abhängigkeit der Richtung eines den Winkelsensor beaufschlagenden magnetischen Feldes vorgesehen ist, wobei die Wheatstoneschen Brücke ein erstes und ein zweites Paar von sich jeweils gegenüberliegenden, parallel zueinander angeordneten magnetoresistiven Widerständen aufweist, wobei das erste und das zweite Paar orthogonal zueinander angeordnet sind und wobei der Winkel mittels einer Auswerteschaltung aus dem von der Wheatstoneschen Brücke gelieferten Winkelsignal ermittelbar ist.

Ein derartiges Verfahren und eine derartige Sensorvorrichtung sind beispielsweise aus dem Datenbuch SC 17 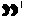 Semiconductor Sensors" der Firma Philips bekannt. Diese bekannte Sensorvorrichtung weist einen magnetoresistiven Winkelsensor KMZ41 auf, welcher aus zwei Wheatstoneschen Brücken mit je vier magnetoresisven Widerständen besteht. Die beiden Wheatstoneschen Brücken sind in einem Winkel von 45° gegeneinander angeordnet. An den Eingang der Wheatstoneschen Brücken wird jeweils eine Eingangsspannung angelegt. Für die Ausgangsspannung der ersten Wheatstoneschen Brücke ergibt sich eine kosinusförmige Abhängigkeit der Ausgangsspannung von dem Winkel des die erste Wheatstonesche Brücke beaufschlagenden Magnetfeldes. Für die zweite Wheatstonesche Brücke ergibt sich eine sinusförmige Abhängigkeit der Ausgangsspannung vom Winkel des die zweite Wheatstonesche Brücke beaufschlagenden magnetischen Feldes. Bei der bekannten Sensorvorrichtung ist eine Auswerteschaltung vorgesehen, welche aus den Ausgangsspannungen der ersten und der zweiten Wheatstoneschen Brücke den Winkel des magnetischen Feldes mittels des sogenannten Cordic-Algorithmus (berechnet. Durch Unreproduzierbarkeiten im Herstellungsprozeß sind die magnetoresistiven Widerstände einer jeden Wheatstoneschen Brücke im allgemeinen ungleich, so daß sich zu jeder Ausgangsspannung eine unbekannte Offset-Spannung addiert. Um eine fehlerfreie Winkelmessung zu ermöglichen, ist daher eine Offset-Kalibrierung erforderlich. Bei dem bekannten Verfahren erfolgt die Kalibrierung mittels eines präzise vor dem Sensor rotierenden Magneten. Die Ermittlung der Offset-Spannungen erfolgt iterativ durch Vergleich des Sensor-Ausgangssignals mir einem pulsweitenmodulierten Signal. Ein derartiges Kalibrierverfahren ist durch das Iterieren zeitaufwendig, benötigt durch den drehenden Magneten während des Kalibriervorganges eine aufwendige Apparatur und benötigt zusätzliche Eingänge der Auswerteschaltung, welche nur zum Trimmen verwendet werden.

Es ist Aufgabe der Erfindung, ein Kalibrierverfahren aufzuzeigen, welches einfacher durchzuführen ist und welches eine weniger aufwendige Auswerteschaltung benötigt.

Diese Aufgabe ist für das Verfahren erfindungsgemäß dadurch gelöst, daß in einem ersten Schritt die Wheatstonesche Brücke mit einem Gleichmagnetfeld beaufschlagt wird, welches derart ausgerichtet ist, daß es weder im wesentlichen senkrecht zu den magnetoresistiven Widerständen des ersten Paares noch im wesentlichen senkrecht zu den magnetoresistiven Widerständen des zweiten Paares der Wheatstoneschen Brücke verläuft, daß in einem zweiten Schritt das Gleichmagnetfeld entfernt wird und daß eine Auswerteschaltung in einem dritten Schritt ohne das Gleichmagnetfeld zur Ermittlung eines Offset-Kalibriersignals vorgesehen ist, wobei das von der Wheatstoneschen Brücke ohne Gleichmagnetfeld gelieferte Winkelsignal ein Maß für den Offset der Wheatstoneschen Brücke ist.

In dem ersten Schritt wird die Wheatstonesche Brücke mit einem Gleichmagnetfeld beaufschlagt. Die Ausgangsspannung der Wheatstoneschen Brücke ist abhängig vom Winkel, unter dem das Gleichmagnetfeld auf die Wheatstonesche Brücke einwirkt. Der Widerstand der einzelnen magnetoresistiven Widerstände der Wheatstoneschen Brücke ist dann am geringsten, wenn das Gleichmagnetfeld senkrecht zu den magnetoresistiven Widerständen verläuft, d.h. senkrecht zu der Längsachse und senkrecht zu der Stromflußrichtung der magnetoresistiven Widerstände. Verläuft das Gleichmagnetfeld senkrecht zu den magnetoresisitiven Widerständen des ersten Paares oder senkrecht zu den magnetoresistiven Widerständen des zweiten Paares der Wheatstoneschen Brücke, so ergibt sich für den Betrag der Ausgangsspannung der Wheatstoneschen Brücke ein Maximum. Erfindungsgemäß soll das die Wheatstonesche Brücke in dem ersten Schritt beaufschlagende Gleichmagnetfeld derart gerichtet sein, daß es weder im wesentlichen senkrecht zu den magnetoresistiven Widerständen des ersten Paares noch im wesentlichen senkrecht zu den magnetoresistiven Widerständen des zweiten Paares der Wheatstoneschen Brücke verläuft. Dies bedeutet, daß die Maximalbereiche der Ausgangsspannung der Wheatstoneschen Brücke vermieden werden sollen. Wenn nun das die Wheatstonesche Brücke beaufschlagende Gleichmagnetfeld in dem zweiten Schritt entfernt wird, hängen die Ausgangsspannungen der Wheatstoneschen Brücke davon ab, unter welchem Winkel das Gleichmagnetfeld auf die Wheatstonesche Brücke eingewirkt hat. Der Erfindung liegt die Erkenntnis zugrunde, daß die Ausgangsspannung in dem zweiten Schritt, d.h. nach Entfernen des Gleichmagnetfeldes, über relativ große Winkelbereiche des Winkels des in dem ersten Schritt wirkenden Gleichmagnetfeldes nur sehr wenig von der Offset-Spannung der Wheatstoneschen Brücke abweicht. Daher ist es möglich, die Offset-Spannung der Wheatstoneschen Brücke aus der Ausgangsspannung bei entferntem Gleichmagnetfeld zu bestimmen. Lediglich dann, wenn das die Wheatstonesche Brücke in dem ersten Schritt beaufschlagende Gleichmagnetfeld senkrecht zu den magnetoresistiven Widerständen des ersten Paares oder senkrecht zu den magnetoresistiven Widerständen des zweiten Paares verläuft, ergeben sich nach Entfernen des Gleichmagnetfeldes größere Abweichungen der dann gemessenen Ausgangsspannung zu der Offset-Spannung.

Die von der Wheatstoneschen Brücke nach Entfernen des Gleichmagnetfeldes gelieferte Ausgangsspanung stellt somit ein Maß für die Offset-Spannung des Wheatstoneschen Brücke dar. Dieses von der Wheatstoneschen Brücke ohne Gleichmagnetfeld gelieferte Ausgangssignal wird daher in dem dritten Schritt mittels der Auswerteschaltung zur Offset-Kalibrierung verwendet.

Dieses Verfahren zur Offset-Kalibrierung erfordert keine aufwendigen Meßapparaturen und läßt sich daher einfach und kostengünstig realisieren. Die Anforderungen an die Winkelgenauigkeit des die Wheatstonesche Brücke beaufschlagenden Gleichmagnetfeldes sind sehr gering, so daß auf eine aufwendige und präzise Montage eines Magneten verzichtet werden kann. Abweichungen bzw. Streuungen des Winkels des Gleichmagnetfeldes von ± 10° sind ohne weiteres tolerierbar und haben kaum Einfluß auf die Genauigkeit der Offset-Kalibrierung.

Gemäß Anspruch 2 ist es vorteilhaft, daß das die Wheatstonesche Brücke beaufschlagende Gleichmagnetfeld in einem Winkel von etwa 45° zu den magnetoresistiven Widerständen des ersten Paares und des zweiten Paares der Wheatstoneschen Brücke verläuft. Bei einem derartigen Winkel ist die Offset-Kalibrierung besonders genau, d.h. die von der Wheatstoneschen Brücke nach Entfernen des Gleichmagnetfeldes gelieferte Ausgangsspannung stimmt besonders gut mit der Offset-Spannung der Wheatstoneschen Brücke überein. Dies ist dadurch zu erklären, daß bei einer derartigen Ausrichtung des Gleichmagnetfeldes der Winkelbetrag zwischen der Stromrichtung der einzelnen magnetoresistiven Widerstände und des Gleichmagnetfeldes für alle magnetoresistiven Widerstände gleich ist. Daher müßten bei einer idealen Wheatstoneschen Brücke auch die Beträge der magnetoresistiven Widerstände alle gleich sein und dementsprechend müßte die Brücke abgeglichen sein, d.h. die Ausgangsspannung der Wheatstoneschen Brücke müßte Null sein.

Gemäß Anspruch 3 weist der magnetoresistive Winkelsensor zwei Wheatstonesche Brücken auf, welche in einem Winkel von 45° zueinander angeordnet sind. Mit einem derartigen magnetoresistiven Winkelsensor kann der eindeutig zu messende Winkelbereich von magnetischen Feldern auf 180° erweitert werden. Außerdem sind bei einem derartigen Sensor die gemessenen Winkel nicht abhängig von der absoluten Amplitude der Winkelsignale. Dies hat zur Folge, daß der gemessene Winkel weitgehend unabhängig von Temperaturschwankungen ist. Eine zusätzliche Temperaturkompensation ist daher nicht erforderlich. Gemäß Anspruch 3 werden die erste und die zweite Wheatstonesche Brücke nacheinander kalibriert. Das zu Anspruch 1 beschriebene Verfahren wird daher zweimal durchgeführt, einmal für die erste Wheatstonesche Brücke und nachfolgend für die zweite Wheatstonesche Brücke.

Gemäß der vorteilhaften Ausgestaltung der Erfindung nach Anspruch 4 erfolgt die Offset-Kalibrierung analog, d.h., das zu der analogen Ausgangsspannung der Wheatstoneschen Brücke eine analoge Offset-Kompensationsspannung addiert wird. Die mittels der analogen Offset-Kompensationsspannung kompensierte analoge Ausgangsspannung der Wheatstoneschen Brücke kann dann mittels der Auswerteschaltung ausgewertet und daraus der Winkel berechnet werden.

Alternativ ist es gemäß Anspruch 5 möglich, eine digitale Offset-Kompensation vorzusehen. Bei der digitalen Offset-Kompensation wird die in dem dritten Schritt am Ausgang der Wheatstoneschen Brücke zur Verfügung stehende Offset-Spannung vorzugsweise digital in einem nichtflüchtigen Speicher abgelegt. Dies ermöglicht im späteren Meßbetrieb eine digitale Offset-Kompensation mittels der Auswerteschaltung.

Das Verfahren nach Anspruch 6 stellt eine vorteilhafte Möglichkeit der analogen Offset-Kompensation dar. Bei dem Verfahren nach Anspruch 6 ist zur Offset-Kompensation der ersten Wheatstoneschen Brücke eine erste Spannungsteilerschaltung und zur Offset-Kompensation der zweiten Wheatstoneschen Brücke eine zweite Spannungsteilerschaltung vorgesehen. Durch Veränderung der Widerstände der Spannungsteiler können zu der Ausgangsspannung der ersten und der zweiten Wheatstoneschen Brücke jeweils Offset-Kompensationsspannungen addiert oder subtrahiert werden, beispielsweise mittels eines Differenzverstärkers. Bei der analogen Offset-Kompensation ist eine analoge Messung der Offset-Kompensationsspannung in dem dritten Schritt sehr aufwendig, da die Ausgangsspannungen der Wheatstoneschen Brücken bis in den Mikrovolt-Bereich genau gemessen werden müssen. Daher wäre für die direkte Messung ein präzises Meßgerät erforderlich. Außerdem könnten durch die externen Meßleitungen leicht Störungen induziert werden, die das Meßergebnis verfälschen könnten. Daher ist es vorteilhaft, zur Ermittlung der optimalen Offset-Kompensationsspannungen die Winkelanzeige der vorhandenen Auswerteschaltung zu benutzen. Im vorliegenden Fall ist die Winkelanzeige nicht mit der Richtung eines anliegenden Magnetfeldes verknüpft, sondern sie ergibt sich aus den aktuellen Ausgangsspannungen der Wheatstoneschen Brücken, welche den Offset-Spannungen entsprechen. Mittels einer geeigneten Variation der Offset-Kompensationsspannungen bei gleichzeitiger Messung der Winkelanzeige ist es nun möglich, die optimalen Kompensationspannungen zu ermitteln. Dies wird nachfolgend näher beschrieben.
So wird gemäß dem vorteilhaften Verfahren nach Anspruch 6 zur Ermittlung der optimalen Offset-Kompensationsspannung der ersten Wheatstoneschen Brücke zunächst zu der Winkelspannung der zweiten Wheatstoneschen Brücke eine vorgebbare Gleichspannung addiert. Dadurch wird eine Voreinstellung des mittels der Auswerteschaltung gemessenen Winkels vorgenommen. Dadurch wird erreicht, daß sich in einem Bereich von ca. ± 10° um diesen voreingestellten Winkel herum eine lineare Abhängigkeit des mittels der Auswerteschaltung ermittelten Winkels von der mittels der ersten Spannungsteilerschaltung zu der Ausgangsspannung der ersten Wheatstoneschen Brücke addierten Trimmspanung ergibt. Die Trimmspannungen stellen Hilfsspannungen zur Ermittlung der optimalen Offset-Kompensationsspannungen dar. Mittels einer Variation der Widerstände der ersten Spannungsteilerschaltung wird zu der Winkelspannung der ersten Wheatstoneschen Brücke eine erste und eine zweite Trimmspannung zu der Winkelspannung der ersten Wheatstoneschen Brücke addiert und jeweils der zugehörige Winkel mittels der Auswerteschaltung ermittelt. Durch Interpolation läßt sich daraus die für eine optimale Offset-Kompensation erforderliche Offset-Kompensationsspannung berechnen. Die so ermittelte optimale Offset-Kompensationsspannungwird dann mittels der ersten Spannungsteilerschaltung eingestellt. Die Variation der Widerstände der ersten und der zweiten Spannungsteilerschaltung kann beispielsweise mittels Lasertrimmmen und/oder mittels Hinzuschaltung von bekannten Widerständen zu jeweils schon vorhandenen Spannungsteilern erfolgen. In analoger Weise kann die optimale Offset-Kompensationsspannung für die zweite Wheatstonesche Brücke ermittelt werden.

Die erfindungsgemäße Aufgabe ist für die Sensorvorrichtung erfindungsgemäß dadurch gelöst, daß die Auswerteschaltung einen Kalibriermodus zur Ermittlung eines Offset-Kalibriersignals aufweist, wobei vor dem Start des Kalibriermodus ein Beaufschlagen der Wheatstoneschen Brücke ruft einem (äußeren) Gleichmagnetfeld, welches derart ausgerichtet ist, daß es weder im wesentlichen parallel zu den magnetoresistiven Widerständen des ersten Paares noch im wesentlichen parallel zu den magnetoresistiven Widerständen des zweiten Paares der Wheatstoneschen Brücke verläuft, sowie ein nachfolgendes Entfernen dieses (äußeren) Gleichmagnetfeldes vorgesehen ist, wobei das von der Wheatstoneschen Brücke ohne Gleichmagnetfeld an die Auswerteschaltung gelieferte Winkelsignal ein Maß für den Offset der Wheatstoneschen Brücke ist.

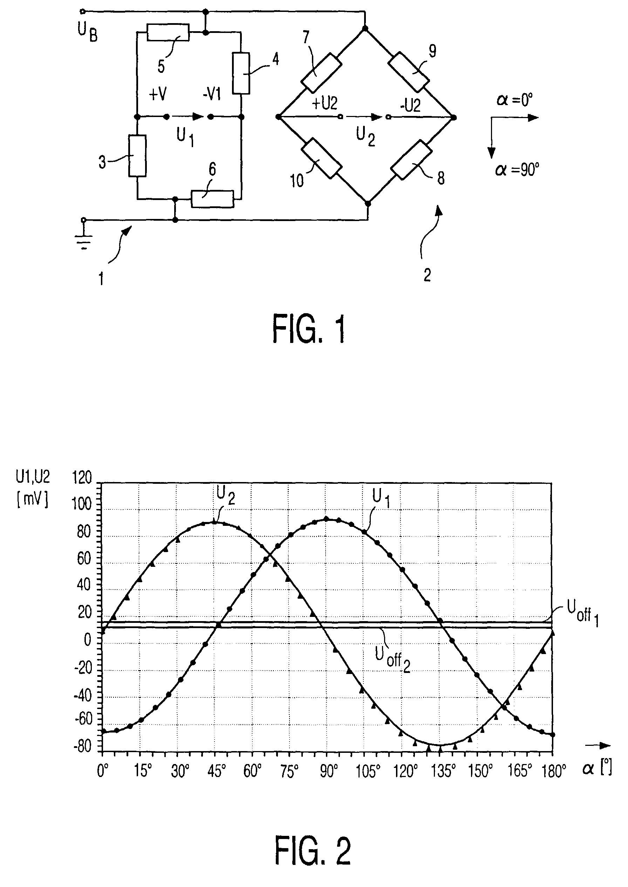

Einige Ausführungsbeispiele der Erfindung werden nachfolgend anhand der Zeichnung in den Fig. 1 bis 7 erläutert. Es zeigen:
Fig. 1 ein schematisches Schaltbild eines Winkelsensors mit zwei Wheatstoneschen Brücken, welche jeweils vier magnetoresistive Widerstände aufweisen und um 45° versetzt zueinander angeordnet sind,

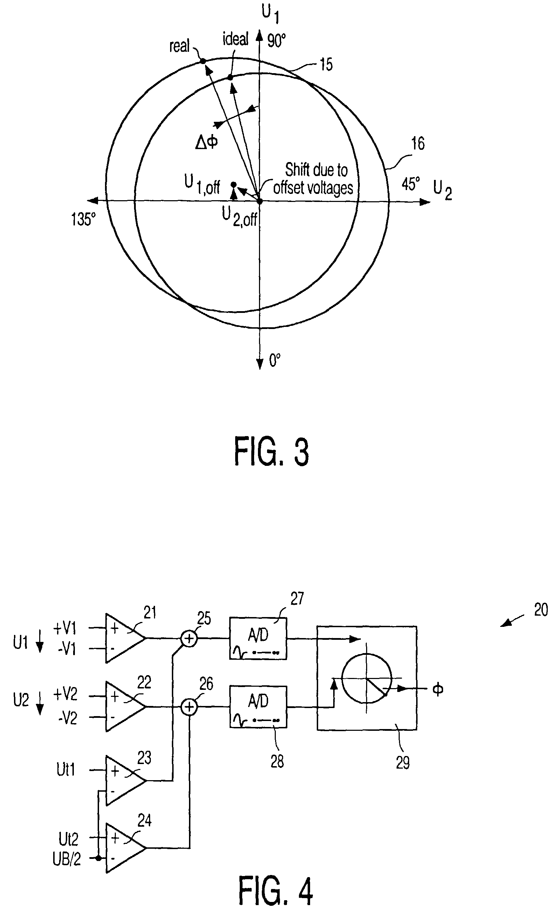

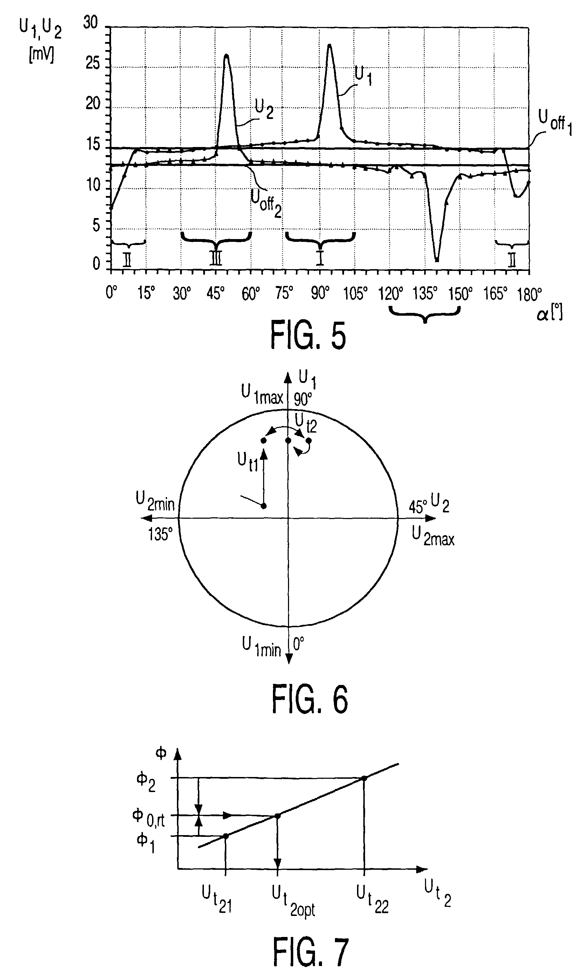

Fig. 2 zeigt den Verlauf der Winkelspannungen der ersten und der zweiten Wheatstoneschen Brücke eines Winkelsensors gemäß Fig. 1 in Abhängigkeit der Richtung des den Winkelsensor beaufschlagenden magnetischen Feldes, wobei die Winkelsignale mit einer Offset-Spannung behaftet sind, Fig. 3 zeigt die Ortskurve der Winkelspannungen des magnetoresistiven Winkelsensors gemäß Fig. 1, Fig. 4 eine schematische Darstellung einer Auswerteschaltung zur Berechnung des Winkels des den Winkelsensor beaufschlagenden magnetischen Feldes in Abhängigkeit der Winkelspannungen der ersten und der zweiten Wheatstoneschen Brücke, Fig. 5 den Verlauf der Winkelspannungen der ersten und der zweiten Wheatstoneschen Brücke eines Winkelsensors gemäß Fig. 1 in Abhängigkeit der Winkelrichtung eines Magnetfeldes, mittels dessen der Winkelsensor in einem ersten Schritt beaufschlagt wurde und welches in einem nachfolgenden zweiten Schritt entfernt wurde, Fig. 6 ein anhand einer Ortskurve veranschaulicht dargestelltes Verfahren zur analogen Offset-Kompensation der zweiten Wheatstoneschen Brücke, wobei die optimale Offset-Kompensationsspannung für die zweite Wheatstonesche Brücke durch lineare Interpolation aus den gemessenen Winkeln zweier Trimmspannungen ermittelt wird, Fig. 7 eine veranschaulichte Darstellung des Trimmverfahrens gemäß Fig. 6, wobei der gemessene Winkel über der Trimmspannung der zweiten Wheatstoneschen Brücke dargestellt ist.

Fig. 1 zeigt einen magnetoresistiven Winkelsensor, welcher eine erste Wheatstonesche Brücke 1 sowie eine zweite Wheatstonesche Brücke 2 aufweist. Die erste Wheatstonesche Brücke 1 weist einen ersten magnetoresistiven Widerstand 3 und gegenüberliegend einen zweiten magnetoresistiven Widerstand 4 auf, welche ein erstes Widerstandspaar bilden. Senkrecht zu diesem ersten Widerstandspaar sind ein dritter magnetoresistiver Widerstand 5 und ein vierter magnetoresistiver Widerstand 6 angeordnet, welche ein zweites Paar von magnetoresistiven Widerständen bilden. Der erste magnetoresistive Widerstand 3 ist einerseits mit dem dritten magnetoresistiven Widerstand 5 und andererseits mit dem vierten magnetoresistiven Widerstand 6 gekoppelt. Der zweite magnetoresistive Widerstand 4 ist einerseits mir dem dritten magnetoresistiven Widerstand 5 und andererseits mit dem vierten magnetoresistiven Widerstand 6 gekoppelt. Der dritte magnetoresistive Widerstand 5 ist einerseits mit dem ersten magnetoresistiven Widerstand 3 und andererseits mit dem zweiten magnetoresistiven Widerstand 4 gekoppelt. Der vierte magnetoresistive Widerstand 6 ist einerseits mit dem ersten magnetoresistiven Widerstand 3 und andererseits mit dem zweiten magnetoresistiven Widerstand 4 gekoppelt. Zwischen dem zweiten magnetoresistiven Widerstand 4 und dem dritten magnetoresistiven Widerstand 5 wird der ersten Wheatstoneschen Brücke 1 eine positive Betriebsspannung U_{B} zugeführt. Zwischen dem ersten magnetoresistiven Widerstand 3 und dem vierten magnetoresistiven Widerstand 6 ist die Wheatstonesche Brücke mit einem Massepotential gekoppelt. Zwischen dem dritten magnetoresistiven Widerstand 5 und dem ersten magnetoresistiven Widerstand 3 ist eine positive Potentialklemme +V₁ vorgesehen und zwischen dem zweiten magnetoresistiven Widerstand 4 und dem vierten magnetoresistiven Widerstand 6 eine negative Potentialklemme - V₁. Zwischen der positiven Potentialklemme +V₁ und der negativen Potentialklemme -V₁ ist eine erste Winkelspannung U₁ abgreifbar.

Die zweite Wheatstonesche Brücke 2 ist analog zu der ersten Wheatstoneschen Brücke 1 aufgebaut, jedoch um 45° versetzt angeordnet. Sie weist einen fünften magnetoresistiven Widerstand 7 und in paralleler Ausrichtung gegenüberliegend einen sechsten magnetoresistiven Widerstand 8 auf. Senkrecht dazu sind einander gegenüberliegend ein siebter magnetoresistiver Widerstand 9 und ein achter magnetoresistiver Widerstand 10 angeordnet. Der fünfte magnetoresistive Wdierstand ist einerseits mit dem siebten magnetoresistiven Widersrand 9 und andererseits mit dem achten magnetoresistiven Widerstand 10 gekoppelt. Der sechste magnetoresistive Widerstand 8 ist einerseits mit dem siebten magnetoresistiven Widerstand 9 und andererseits mit dem achten magnetoresistiven Widerstand 10 gekoppelt. Zwischen dem fünften magnetoresistiven Widerstand 7 und dem siebten magnetoresistiven Widerstand 9 ist die zweite Wheatstonesche Brücke 2 mit der positiven Betriebsspannung U_{B} gekoppelt. Zwischen dem sechsten magnetoresistiven Widerstand 8 und dem achten magnetoresistiven Widerstand 10 ist die zweite Wheatstonesche Brücke 2 mit Massepotential gekoppelt. Der fünfte magnetoresistive Widerstand 7 und der achte magnetoresistive Widerstand 8 bilden ein erstes Paar. Der siebte magnetoresistive Widerstand 9 und der achte magnetoresistive Widerstand 10 bilden ein zweites Paar. Zwischen dem fünften magnetoresistiven Widerstand 7 und dem achten magnetoresistiven Widerstand 10 ist eine positive Potentialklemme +V₂ vorgesehen. Zwischen dem siebten magnetoresistiven Widerstand 9 und dem sechsten magnetoresistiven Widerstand 8 ist eine negative Potentialklemme -V₂ vorgesehen. Zwischen der positiven Potentialklemme +V₂ und der negativen Potentialklemme-V₂ ist eine zweite Winkelspannung U₂ abgreifbar.

Fig. 2 zeigt den Verlauf der ersten Winkelspannung U₁ der ersten Wheatstoneschen Brücke 1 gemäß Fig. 1 und den Verlauf der zweiten Winkelspannung U₂ der zweiten Wheatstoneschen Brücke 2 gemäß Fig. 1 in Abhängigkeit einer Winkelrichtung α eines den Winkelsensor gemäß Fig. 1 beaufschlagenden magnetischen Feldes. Das Bezugskoordinatensystem ist dabei gemäß Fig. 1 definiert. Der Winkel α = 0° erstreckt sich in Längsrichtung des dritten magnetoresistiven Widerstandes 5 und des vierten magnetoresistiven Widerstandes 6, senkrecht zu der Längsrichtung des ersten magnetoresistiven Widerstandes 3 und des zweiten magnetoresistiven Widerstandes 4 sowie jeweils in einem Winkel von 45° zu den magnetoresistiven Widerständen 7, 8, 9 und 10 der zweiten Wheatstoneschen Brücke 2. Für die erste Winkelspannung U₁ ergibt sich eine negativ kosinusförmige Abhängigkeit vom zweifachen Winkel 2 α des die erste Wheatstonesche Brücke 1 beaufschlagenden magnetischen Feldes. Für die zweite Winkelspannung U₂ ergibt sich eine sinusförmige Abhängigkeit vom zweifachen Winkel 2 α des die zweite Wheatstonesche Brücke 2 beaufschlagenden magnetischen Feldes. Durch Unreproduzierbarkeiten im Herstellungsprozeß sind die Widerstandswerte der einzelnen magnetoresistiven Widerstände der ersten Wheatstoneschen Brücke 1 und der zweiten Wheatstoneschen Brücke 2 im allgemeinen ungleich, so daß die erste Winkelspannung U₁ mit einer ersten Offset-Spannung U_{Off1} behaftet ist und die zweite Winkelspannung U₂ mit einer zweiten Offset-Spannung U_{Off2}. Die erste Offset-Spannung U_{Off1} und die zweite Offset-Spannung U_{Off2} verursachen einen Fehler bei der Winkel- bzw. Richtungsmessung des den Winkelsensor beaufschlagenden magnetischen Feldes und müssen daher durch ein geeignetes Kalibrierverfahren bestimmt bzw. eliminiert werden.

Fig. 3 zeigt die reale Ortskurve 15 der ersten Winkelspannung U₁ und der zweiten Winkelspannung U₂ gemäß Fig. 2. Gleichzeitig ist die ideale Ortskurve 16 für ideale Winkelspannungen U₁ und U₂ eingezeichnet, welche nicht mit einer Offset-Spannung behaftet sind. Die ideale Ortskurve 16 ist ein Kreis und der Mittelpunkt liegt genau im Koordinatenursprung. Die nicht ideale Ortskurve 15 der realen, mit einer Offset-Spannung behafreten ersten Winkelspannung U₁ und zweiten Winkelspannung U₂ ist ebenfalls ein Kreis, dessen Mittelpunkt jedoch gegenüber dem Koordinatenursprung um die erste Offset-Spannung U_{Off1} sowie die zweite Offset-Spannung U_{Off2} verschoben ist. Daraus ergibt sich bei der Winkelmessung ein Meßfehler Δφ.

Fig. 4 zeigt ein prinzipielles Blockschaltbild einer Auswerteschaltung 20, welche zur Berechnung des den Winkelsensor beaufschlagenden magnetischen Feldes aus der ersten Winkelspannung U₁ der ersten Wheatstoneschen Brücke 1 und der zweiten Winkelspannung U₂ der zweiten Wheatstoneschen Brücke 2 vorgesehen ist. Die Auswerteschaltung 20 weist einen ersten Differenzverstärker 21, einen zweiten Differenzverstärker 22, einen dritten Differenzverstärker 23 und einen vierten Differenzverstärker 24 auf. Die Differenzverstärker 21 und 22 haben einen größeren Verstärkungsfaktor als die Differenzverstärker 23 und 24. Der nichtin vertierende Eingang des ersten Differenzverstärkers 21 ist mit der positiven Potentialklemme +V₁ der ersten Wheatstoneschen Brücke 1 gemäß Fig. 1 gekoppelt. Der invertierende Eingang des ersten Differenzverstärkers 21 ist mit der negativen Potentialklemme -V₁ der ersten Wheatstoneschen Brücke 1 gemäß Fig. 1 gekoppelt. Der nichtinvertierende Eingang des zweiten Differenzverstärkers 21 ist mit der positiven Potentialklemme +V₂ der zweiten Wheatstoneschen Brücke 2 gemäß Fig. 1 gekoppelt. Der invertierende Eingang des zweiten Differenzverstärkers 22 ist mit der negativen Potentialklemme -V₂ der zweiten Wheatstoneschen Brücke 2 gemäß Fig. 1 gekoppelt. Dem nichtinvertierenden Eingang des dritten Differenzverstärkers 23 wird eine Trimmspannung Uₜ₁ zugeführt und dem nichtinvertierenden Eingang des vierten Differenzverstärkers 24 eine Trimmspannung Uₜ₂. Den invertierenden Eingänge des dritten Differenzverstärkers 23 und des vierten Differenzverstärkers 24 wird das halbe Potential der Betriebsspannung U_{B2} zugeführt. Der Ausgang des ersten Differenzverstärkers 21 und des dritten Differenzverstärkers 23 werden auf eine erste Addierstufe 25 geführt. Der Ausgang des zweiten Differenzverstärkers 22 und des vierten Differenzverstärkers 24 werden auf eine zweite Addierstufe 26 geführt. Der Ausgang der ersten Addierstufe 25 ist mit einem ersten A/D-Wandler 27 gekoppelt und der Ausgang der zweiten Addierstufe 26 mir einem zweiten A/D-Wandler 28. Der Ausgang des ersten A/D-Wandlers 27 und der Ausgang des zweiten A/D-Wandlers 28 sind mit einer digitalen Winkelberechnungsschaltung 29 gekoppelt. Mittels des ersten Differenzverstärkers 21 wird somit die erste Winkelspannung U₁ der ersten Wheatstoneschen Brücke 1 verstärkt und mittels des zweiten Differenzverstärkers 22 wird die zweite Winkelspannung U₂ der zweiten Wheatstoneschen Brücke 2 verstärkt. Der Offset der ersten Winkelspannung U₁ kann mittels der Trimmspannung Uₜ₁ eliminiert werden, welche der ersten Addierstufe 25 über den dritten Differenzverstärker 23 zugeführt und dort zu dem mittels des Differenzverstärkers 21 verstärkten ersten Winkelsignals U₁ addierbar ist. Der Offset der zweiten Winkelspannung U₂ der zweiten Wheatstoneschen Brücke 2 kann mittels der Trimmspannung Uₜ₂ eliminiert werden, welche über den vierten Differenzverstärker 24 der zweiten Addierstufe 26 zugeführt wird und dort zu der mittels des zweiten Differenzverstärkers 22 verstärkten zweiten Winkelspannung U₂ addierbar ist. Bei der Auswerteschaltung gemäß Fig. 4 erfolgt somit eine analoge Offset-Kompensation. Nach der Offset-Kompensation der ersten Winkelspannung U₁ und der zweiten Winkelspannung U₂ in der ersten Addierstufe 25 bzw. der zweiten Addierstufe 26 erfolgt eine Analog-Digital-Wandlung mittels des ersten A/D-Wandlers 27 und des zweiten A/D-Wandlers 28. Aus den Ausgangssignalen des ersten A/D-Wandlers 27 und des zweiten A/D-Wandlers 28 berechnet die digitale Winkelberechnungsschaltung 29 den Winkel φ des die erste Wheatstonesche Brücke 1 und die zweite Wheatstonesche Brücke 2 beaufschlagenden magnetischen Feldes. Hierzu wird vorzugsweise der Cordic-Algorithmus verwendet.

Fig. 5 zeigt die erste Winkelspannung U₁ der ersten Wheatstoneschen Brücke 1 und die Ausgangsspannung U₂ der zweiten Wheatstoneschen Brücke 2 in Abhängigkeit der Winkelrichtung α eines magnetischen Feldes, mit dem die erste Wheatstonesche Brücke 1 und die zweite Wheatstonesche Brücke 2 in einem ersten Schritt beaufschlagt worden sind, und welches in einem zweiten Schritt entfernt worden ist. Gleichzeitig sind in Fig. 5 die erste Offset-Spannung U_{Off1} der ersten Wheatstoneschen Brücke 1 und die zweite Offset-Spannung U_{Off2} der zweiten Wheatstoneschen Brücke 2 eingezeichnet. In Fig. 5 ist deutlich zu erkennen, daß die erste Winkelspannung U₁ nach Entfernen des die erste Wheatstonesche Brücke 1 beaufschlagenden magnetischen Feldes in einem Bereich von 15 bis 75° sowie in einem Bereich von 105 bis 165° nur sehr wenig von der Offset-Spannung U_{Off1} abweicht. Die beste Übereinstimmung zwischen der Offset-Spannung U_{Off1} und der Winkelspannung U₁ bei entferntem äußeren Magnetfeld ergibt sich bei einem Winkel α von 45°. Die Winkelspannung U₂ der zweiten Wheatstoneschen Brücke 2 stimmt in einem Winkelbereich von 60 bis 120°, in einem Winkelbereich von 0 bis 30° sowie in einem Winkelbereich 165 bis 180° weitgehend mit der Offset-Spannung U_{Off2} überein. Die beste Übereinstimmung ergibt sich bei einem Winkel von ca. 90°. Lediglich in bestimmten relativ kleinen Winkelbereichen liegt eine sehr große Abweichung zwischen den gemessenen Winkelspannung U₁ und U₂ und den zugehörigen Offset-Spannungen U_{Off1} und U_{Off2} vor. Für die erste Winkelspannung U₁ ergeben sich größere Abweichungen in einem Winkelbereich I von 75 bis 105° sowie in einem Winkelbereich II von 165 bis 15°. Für die zweite Winkelspannung U₂ ergeben sich größere Abweichungen in einem Winkelbereich III von 30 bis 60° sowie in einem Winkelbereich IV von 120 bis 150°.

Der aus der Fig.5 hervorgehende Zusammenhang kann zur Kalibrierung der ersten Wheatstoneschen Brücke 1 und der zweiten Wheatstoneschen Brücke 2 verwendet werden. Zur Kalibrierung der ersten Wheatstoneschen Brücke 1 wird die erste Wheatstonesche Brücke 1 mittels eines Gleichmagneten in einem ersten Schritt mir einem äußeren Gleichmagnetfeld beaufschlagt, welches derart ausgerichtet ist, daß es weder in dem Winkelbereich I noch in dem Winkelbereich II liegt. Vorzugsweise wird ein Winkel α von ca. 45° bzw. ca. 135° eingestellt. In dem zweiten Verfahrensschritt wird dann der Gleichmagnet und damit das äußere Gleichmagnetfeld entfernt. Nun stimmt die erste Winkelspannung U₁ am Ausgang der ersten Wheatstoneschen Brücke 1 weitgehend mit der Offset-Spannung U_{Off1} überein. In einem dritten Schritt kann nun die Auswerteschaltung 20 gemäß Fig. 4 eine Offset-Kalibrierung der ersten Wheatstoneschen Brücke 1 vornehmen. Zur Offset-Kalibrierung der zweiten Wheatstoneschen Brücke 2 wird die zweite Wheatstonesche Brücke 2 in einem vierten Schritt mit einem äußeren Gleichmagnetfeld beaufschlagt, welches derart gerichtet ist, daß es weder in dem Winkelbereich III noch in dem Winkelbereich IV gemäß Fig. 5 liegt. Vorzugsweise ist das äußere Gleichmagnetfeld so gerichtet, daß sich ein Winkel α von 90° ergibt. In einem nachfolgenden fünften Verfahrensschritt wird das äußere Gleichmagnetfeld dann entfernt. Die nun am Ausgang der zweiten Wheatstoneschen Brücke 2 zur Verfügung stehende zweite Winkelspannung U₂ stimmt nun weitgehend mit der Offset-Spannung U_{Off2} der zweiten Wheatstoneschen Brücke 2 überein. Die Auswerteschaltung 20 gemäß Fig. 4 kann nun eine Offset-Kalibrierung der zweiten Wheatstoneschen Brücke 2 vornehmen.

Ein vorteilhaftes Verfahren zur Bestimmung der Trimm-Spannung Uₜ₂ des vierten Differenzverstärkers 24 der Auswerteschaltung 20 gemäß Fig. 4 ist in der Fig. 6 dargestellt. Nachdem die zweite Wheatstonesche Brücke 2 mit einem äußeren Gleichmagnetfeld beaufschlagt worden ist und dieses äußere Gleichmagnetfeld entfernt worden ist, sind die erste Winkelspannung U₁ und die zweite Winkelspannung U₂ relativ klein, d.h. in der Ortskurvendarstellung der ersten Winkelspannung U₁ und der zweiten Winkelspannung U₂ gemäß Fig. 6 befindet sich der Punkt, der aus U₁ und U₂ gebildet wird, in der Nähe des Ursprungs des Koordinatensystems. Um Nichtlinearitäten zu vermeiden, wird zu der ersten Winkelspannung U₁ mittels des dritten Differenzverstärkers 23 und der ersten Addierstufe 25 die maximal mögliche Trimm-Spannung Uₜ₁ₘₐₓ addiert. Dann werden zu der zweiten Winkelspannung U₂ über den zweiten Differenzverstärker 24 und die zweite Addierstufe 26 zunächst eine erste Trimm-Spannung Uₜ₂₁ addiert und mittels der digitalen Winkelberechnungsschaltung 29 wird der zugehörige Winkel φ₁ berechnet. Danach wird eine zweite größere Trimmspannung Uₜ₂₂ zu der zweiten Winkelspannung U₂ addiert und erneut mittels der digitalen Winkelberechnungsschaltung 29 der Winkel φ₂ berechnet. Die so mittels der digitalen Winkelberechnungsschaltung 29 berechneten Winkel stimmen bei einer mit einem Offset behafteten Wheatstoneschen Brücke 2 nicht mit dem idealen Winkel von φₒₚₜ = 90° überein, welcher bei einer Wheatstoneschen Brücke 2 ohne Offset gemessen werden müßte. Durch lineare Interpolation kann nun die optimale Trimm-Spannung Uₜ₂ₒₚₜ mittels der Auswerteschaltung 20 berechnet werden, bei der der mittels der digitalen Winkelberechnungsschaltung berechnete Winkel dem tatsächlich zu messenden Winkel von φₒₚₜ =90° entspricht. Diese lineare Interpolation ist in der Fig. 7 dargestellt.

## Patentansprüche

1. Verfahren zur Offset-Kalibrierung eines magnetoresistiven Winkelsensors zur Richtungsermittlung von magnetischen Feldern, welcher wenigstens eine Wheatstonesche Brücke mit wenigstens vier magnetoresistiven Widerständen aufweist, wobei der Wheatstoneschen Brücke eingangsseitig ein Eingangssignal, insbesondere eine Eingangsspannung, zuführbar ist und wobei die Wheatstonesche Brücke ausgangsseitig zur Lieferung eines Winkelsignals, insbesondere einer Winkelspannung, in Abhängigkeit der Richtung eines die Wheatstonesche Brücke beaufschlagenden magnetischen Feldes vorgesehen ist, wobei die Wheatstonesche Brücke ein erstes und ein zweites Paar von sich jeweils gegenüberliegenden, im wesentlichen parallel zueinander angeordneten magnetoresistiven Widerständen aufweist, wobei das erste und das zweite Paar im wesentlichen orthogonal zueinander angeordnet sind und wobei die Richtung des magnetischen Feldes aus dem von der Wheatstoneschen Brücke gelieferten Winkelsignal mittels einer Auswerteschaltung ermittelbar ist, dadurch gekennzeichnet,
daß in einem ersten Schritt die Wheatstonesche Brücke mit einem Gleichmagnetfeld beaufschlagt wird, welches derart ausgerichtet ist, daß es weder im wesentlichen senkrecht zu den magnetoresistiven Widerständen des ersten Paares noch im wesentlichen senkrecht zu den magnetoresistiven Widerständen des zweiten Paares der Wheatstoneschen Brücke verläuft, daß in einem zweiten Schritt das Gleichmagnetfeld entfernt wird und daß eine Auswerteschaltung in einem dritten Schritt ohne das äußere Gleichmagnetfeld zur Ermittlung eines Offset-Kalibriersignals vorgesehen ist, wobei das von der Wheatstoneschen Brücke ohne Gleichmagnetfeld gelieferte Winkelsignal ein Maß für den Offset der Wheatstoneschen Brücke ist.

2. Verfahren nach Anspruch 1, dadurch gekennzeichnet,
daß in dem ersten Schritt die Wheatstonesche Brücke mit einem Gleichmagnetfeld beaufschlagt wird, welches derart ausgerichtet ist, daß es jeweils in einem Winkel von etwa 45° zu den magnetoresistiven Widerständen des ersten Paares und den magnetoresistiven Widerständen des zweiten Paares der Wheatstoneschen Brücke verläuft.

3. Verfahren nach Anspruch 1, dadurch gekennzeichnet,
daß der Winkelsensor eine erste und eine zweite Wheatstonesche Brücke aufweist, welche in einem Winkel von etwa 45° zueinander angeordnet sind, daß in dem ersten Schritt die erste Wheatstonesche Brücke mit einem Gleichmagnetfeld beaufschlagt wird, welches derart ausgerichtet ist, daß es weder im wesentlichen parallel zu den magnetoresistiven Widerständen des ersten Paares der ersten Wheatstoneschen Brücke noch irrt wesentlichen parallel zu den magnetoresistiven Widerständen des zweiten Paares der ersten Wheatstoneschen Brücke verläuft, daß in dem zweiten Schritt das Gleichmagnetfeld entfernt wird und daß die Auswerteschaltung in dem dritten Schritt ohne das Gleichmagnetfeld zur Ermittlung eines Offset-Kalibriersignals für die erste Wheatstonesche Brücke vorgesehen ist, wobei das von der ersten Wheatstoneschen Brücke ohne Gleichmagnetfeld gelieferte Winkelsignal ein Maß für den Offset der ersten Wheatstoneschen Brücke ist, daß in einem vierten Schritt die zweite Wheatstonesche Brücke mit einem Gleichmagnetfeld beaufschlagt wird, welches derart ausgerichtet ist, daß es weder im wesentlichen parallel zu den magnetoresistiven Widerständen des ersten Paares der zweiten Wheatstoneschen Brücke noch im wesentlichen parallel zu den magnetoresistiven Widerständen des zweiten Paares der zweiten Wheatstoneschen Brücke verläuft, daß in einem fünften Schritt das Gleichmagnetfeld entfernt wird und daß die Auswerteschaltung in einem sechsten Schritt ohne das Gleichmagnetfeld zur Ermittlung eines Offset-Kalibriersignals für die zweite Wheatstonesche Brücke vorgesehen ist, wobei das von der zweiten Wheatstoneschen Brücke ohne Gleichmagnetfeld gelieferte Winkelsignal ein Maß für den Offset der zweiten Wheatstoneschen Brücke ist.

4. Verfahren nach Anspruch 1, dadurch gekennzeichnet,
daß die Offset-Kalibrierung analog mittels Addition einer Offset-Kompensationsspannung zu der von der Wheatstoneschen Brücke gelieferten Winkelspannung erfolgt.

5. Verfahren nach Anspruch 1, dadurch gekennzeichnet,
daß die Offset-Kompensation digital mittels der Auswerteschaltung erfolgt.

6. Verfahren nach Anspruch 4, dadurch gekennzeichnet,
daß die Auswerteschaltung zur Offset-Kompensation der ersten Wheatstoneschen Brücke eine erste Spannungsteilerschaltung und zur Offset-Kompensation der zweiten Wheatstoneschen Brücke eine zweite Spannungsteilerschaltung aufweist, mittels derer zu der von der ersten bzw. zweiten Wheatstoneschen Brücke gelieferten Winkelspannung jeweils eine Offset-Kompensationsspannung addierbar ist, daß zur Ermittlung der optimalen Offset-Kompensationsspannung der ersten Wheatstoneschen Brücke zu der Winkespannung der zweiten Wheatstoneschen Brücke eine vorgebbare Gleichspannung addiert wird, daß mittels Variation der Widerstände der ersten Spannungsteilerschaltung wenigstens eine erste und eine zweite Trimmspannung zu der Winkelspannung der ersten Wheatstoneschen Brücke addiert und der zugehörige Winkel mittels der Auswerteschaltung ermittelt wird und daß die Auswerteschaltung mittels einer Interpolation die optimale Offset-Kompensationsspannung für die erste Wheatstonesche Brücke berechnet, daß zur Ermittlung der optimalen Offset-Kompensationsspannung der zweiten Wheatstoneschen Brücke zu der Winkelspannung der ersten Wheatstoneschen Brücke eine vorgebbare Gleichspannung addiert wird, daß mittels Variation der Widerstände der zweiten Spannungsteilerschaltung wenigstens eine erste und eine zweite Trimmspannung zu der Winkelspannung der zweiten Wheatstoneschen Brücke addiert und der zugehörige Winkel mittels der Auswerteschaltung ermittelt wird und daß die Auswerteschaltung mittels einer Interpolation die optimale Offset-Kompensationsspanung für die zweite Wheatstonesche Brücke berechnet.

7. Sensorvorrichtung zur Winkelmessung eines Magnetfeldes mit einem magnetoresistiven Winkelsensor, welcher wenigstens eine Wheatstonesche Brücke mit wenigstens vier magnetoresistiven Widerständen aufweist, wobei der Wheatstoneschen Brücke eingangsseitig ein Eingangssignal, insbesondere eine Eingangsspannung, zuführbar ist und wobei der Winkelsensor ausgangsseitig zur Lieferung eines Winkelsignals in Abhängigkeit der Richtung eines den Winkelsensor beaufschlagenden magnetischen Feldes vorgesehen ist, wobei die Wheatstoneschen Brücke ein erstes und ein zweites Paar von sich jeweils gegenüberliegenden, parallel zueinander angeordneten magnetoresistiven Widerständen aufweist, wobei das erste und das zweite Paar orthogonal zueinander angeordnet sind und wobei der Winkel mittels einer Auswerteschaltung aus dem von der Wheatstoneschen Brücke gelieferten Winkelsignal ermittelbar ist, dadurch gekennzeichnet,
daß die Auswerteschaltung einen Kalibriermodus zur Ermittlung eines Offset-Kalibriersignals aufweist, wobei vor dem Start des Kalibriermodus ein Beaufschlagen der Wheatstoneschen Brücke mit einem (äußeren) Gleichmagnetfeld, welches derart ausgerichtet ist, daß es weder im wesentlichen parallel zu den magnetoresistiven Widerständen des ersten Paares noch im wesentlichen parallel zu den magnetoresistiven Widerständen des zweiten Paares der Wheatstoneschen Brücke verläuft, sowie ein nachfolgendes Entfernen dieses (äußeren) Gleichmagnetfeldes vorgesehen ist, wobei das von der Wheatstoneschen Brücke ohne Gleichmagnetfeld an die Auswerteschaltung gelieferte Winkelsignal ein Maß für den Offset der Wheatstoneschen Brücke ist.

8. Sensorvorrichtung nach Anspruch 7, dadurch gekennzeichnet,
daß die Auswerteschaltung einen AD-Wandler aufweist, welcher zur Messung des von der Wheatstoneschen Brücke im Kalibriermodus ohne Gleichmagnetfeld gelieferten Winkelsignals vorgesehen ist und daß die Auswerteschaltung einen nichtflüchtigen Speicher zur digitalen Speicherung des mittels des AD-Wandlers gewandelten Winkelsignals aufweist.

9. Sensorvorrichtung nach Anspruch 7, dadurch gekennzeichnet,
daß die Auswerteschaltung zur Offset-Kompensation der Wheatstoneschen Brücke eine Spannungsteilerschaltung aufweist, mittels derer zu der von der Wheatstoneschen Brücke gelieferten Winkelspannung eine Offset-Kompensationsspannung addierbar ist.
